(19) Europäisches Patentamt
European Patent Office
Office européen des brevets

(11) Veröffentlichungsnummer: **0 089 506**
**A2**

# (12) EUROPÄISCHE PATENTANMELDUNG

(21) Anmeldenummer: **83101809.8**

(51) Int. Cl.³: **G 03 F 7/08**

(22) Anmeldetag: **24.02.83**

(30) Priorität: **18.03.82 US 359336**

(43) Veröffentlichungstag der Anmeldung:
**28.09.83 Patentblatt 83/39**

(84) Benannte Vertragsstaaten:
**DE FR GB NL**

(71) Anmelder: **AMERICAN HOECHST CORPORATION**
**Route 202-206 North**
**Somerville, N.J. 08876(US)**

(72) Erfinder: **Walls, John E.**
**46, Center Street**
**Annandale New Jersey 08801(US)**

(72) Erfinder: **Dhillon, Major S.**
**896C Merritt Dr.**
**Hillsborough New Jersey 08876(US)**

(74) Vertreter: **Euler, Kurt Emil, Dr. et al,**
**KALLE Niederlassung der Hoechst AG Rheingaustrasse**
**190 Postfach 3540**
**D-6200 Wiesbaden 1(DE)**

(54) **Lichtempfindliches Gemisch auf Basis von Diazoniumsalz-Polykondensationsprodukten und daraus hergestelltes lichtempfindliches Aufzeichnungsmaterial.**

(57) Es wird ein lichtempfindliches Gemisch beschrieben, das ein lichtempfindliches Diazoniumsalz-Polykondensationsprodukt und zur Erhöhung der Lichtempfindlichkeit ein unsubstituiertes oder durch eine Azo- oder Hydroxygruppe substituiertes Amin enthält.

EP 0 089 506 A2

Croydon Printing Company Ltd

0089506

AMERICAN HOECHST CORPORATION
Somerville, N.J. 08876/USA



Lichtempfindliches Gemisch auf Basis von Diazoniumsalz-Polykondensationsprodukten und daraus hergestelltes lichtempfindliches Aufzeichnungsmaterial

Die vorliegende Erfindung betrifft lichtempfindliche Gemische auf Basis von Diazoniumsalz-Polykondensationsprodukten sowie daraus hergestellte vorsensibilisierte Aufzeichnungsmaterialien, z. B. Farbprüffolien, Filmvorlagen und andere nicht zum Drucken bestimmte reprographische Materialien.

Vorsensibilisierte Reproduktionsmaterialien, z. B. solche, die zur Herstellung von Kontaktvorlagen bestimmt sind, bestehen im allgemeinen aus einem Schichtträger, der mit einem lichtempfindlichen Gemisch beschichtet ist. Der Schichtträger besteht aus einem biegsamen blattförmigen Material, z. B. aus Papier, Kunststoff, metallbeschichtetem Kunststoff oder einer Kombination von Papier und Kunststoff. Geeignete Kunststoffe sind Polyester, Polystyrol, Polypropylen, Celluloseacetat usw. Gegebenenfalls kann auf den Schichtträger noch eine haftvermittelnde Schicht aufgetragen werden, die für eine feste Verankerung der anschließend aufgetragenen lichtempfindlichen Beschichtung sorgt. Geeignete Haftvermittler sind Silan- und Siloxanverbindungen.

Zu den genannten Diazoniumsalz-Polykondensationsprodukten gehören höhermolekulare Gemische, die z. B. durch Kondensation von bestimmten aromatischen Diazoniumsalzen mit

AMERICAN HOECHST CORPORATION
Somerville, N.J. 08876/USA



aktiven Carbonylverbindungen wie Formaldehyd in einem sauren Kondensationsmedium erhalten werden und u. a. in den US-PS 2 063 631 und 2 667 415 beschrieben sind.

In jüngerer Zeit wurden verbesserte Diazoniumverbindungen der oben erwähnten Art entwickelt, die eine höhere Lichtempfindlichkeit besitzen, besser auf den Trägermaterialien haften und weniger empfindlich gegenüber Feuchtigkeit sind. Dazu gehören Polykondensationsprodukte aus wiederkehrenden Einheiten $A-N_2X$ und B, die durch zweibindige, von einer kondensationsfähigen Carbonylverbindung abgeleitete Zwischenglieder verbunden sind, wobei die Einheiten $A-N_2X$ sich aus Verbindungen der allgemeinen Formel

$$(R^1-R^3-)_pR^2-N_2X$$

ableiten und wobei

X das Anion der Diazoniumverbindung,
p eine ganze Zahl von 1 bis 3,
$R^1$ einen carbocyclischen oder heterocyclischen aromatischen Rest mit mindestens einer kondensationsfähigen Position,
$R^2$ eine Arylengruppe der Benzol- oder Naphthalinreihe,
$R^3$ eine Einfachbindung oder eine der Gruppen:

$-(CH_2)_q-NR^4-$,

$-O-(CH_2)_r-NR^4-$,

AMERICAN HOECHST CORPORATION
Somerville, N.J. 08876/USA



$-S-(CH_2)_r-NR^4-$,

$-S-CH_2-CO-NR^4-$,

$-O-R^5-O-$,

$-O-$,

$-S-$ oder

$-CO-NR^4-$

bedeuten, worin

q eine Zahl von 0 bis 5,
r eine Zahl von 2 bis 5,
$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^5$ eine Arylengruppe mit 6 bis 12 C-Atomen ist, und

B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeutet,

wobei das Kondensationsprodukt im Mittel 0,01 bis 50 Einheiten B je Einheit $A-N_2X$ enthält.

AMERICAN HOECHST CORPORATION
Somerville, N.J. 08876/USA



Verbindungen dieses Typs sind in der US-PS 3 867 147 beschrieben.

Eine weitere Gruppe hochlichtempfindlicher Diazoniumsalz-Kondensationsprodukte sind in der EP-OS 61 150 beschrieben.

Diese Verbindungen sind Polykondensationsprodukte aus wiederkehrenden Einheiten der allgemeinen Typen

$[A - N_2X]$ und $[Q]$ ,

in denen

A der Rest einer Verbindung der allgemeinen Formel I

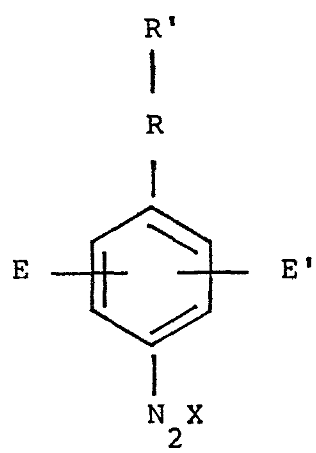

(I)

ist, worin

R' eine gegebenenfalls substituierte Phenylgruppe darstellt,

R -NH-, -S-, -O-, $-CH_2-$ oder eine Einfachbindung ist,

AMERICAN HOECHST CORPORATION
Somerville, N.J. 08876/USA



E und E' gleich oder verschieden sein können und Alkyl- oder Alkoxygruppen mit 1 bis 4 C-Atomen oder Wasserstoffatome sind und

X das Anion des Diazoniumsalzes ist,

Q der Rest einer Verbindung der allgemeinen Formel II

$$R''-M(-Y-M)_m-R'' \quad \text{(mit T am M in der Klammer)} \qquad (II)$$

ist, worin

R" $-CH_2OH$, $-C(OH)(CH_3)_2$, $-CH_2O(CH_2)_nCH_3$, $-CH_2OCOCH_3$, $-CH_2Cl$ oder $-CH_2Br$,

n 0 oder eine Zahl von 1 bis 3,

M der Rest eines aromatischen Kohlenwasserstoffs, Phenolethers, aromatischen Thioethers, aromatischen Amins, aromatischen Sulfons, aromatischen Ketons oder Diketons,

m eine Zahl von 0 bis 9,

Y $-CH_2-$ oder $-CH_2OCH_2-$ und

T ein Wasserstoffatom ist, wenn Y $-CH_2-O-CH_2-$ bedeutet, und ein Rest R" ist, wenn Y $-CH_2-$ bedeutet.

Diese Kondensationsprodukte werden hergestellt, indem man

a) in einem stark sauren Medium eine Verbindung der Formel R"-M-R" so lange und bei solcher Temperatur kondensiert,

AMERICAN HOECHST CORPORATION
Somerville, N.J. 08876/USA



daß ein Kondensationsprodukt der Formel II gebildet wird, worin die Symbole die oben angegebene Bedeutung haben, und

b) das erhaltene Vorkondensationsprodukt in stark saurem Medium mit einer Verbindung der Formel I kondensiert, worin die Symbole ebenfalls die oben angegebene Bedeutung haben.

Zwar weisen die in jüngerer Zeit entwickelten hochlichtempfindlichen Diazoverbindungen hinsichtlich ihrer Qualität und Lichtempfindlichkeit eine Reihe von Vorteilen auf, was sie besonders geeignet erscheinen läßt für Anwendungsgebiete, in denen die Belichtung bei geringer Lichtenergie stattfindet, einschließlich Laserbelichtung, aber es besteht dennoch ein Bedarf an Gemischen mit noch größerer Lichtempfindlichkeit. Farbprüf- und ähnliche Folien, die mit Gemischen beschichtet sind, die Mittel zur Erhöhung der Lichtempfindlichkeit enthalten, eröffnen Möglichkeiten zu noch zeitsparenderen, effizienteren und rentableren Reproduktionsverfahren.

Aufgabe der vorliegenden Erfindung ist es, ein lichtempfindliches Gemisch auf der Basis von Diazoniumsalz-Polykondensationsprodukten vorzuschlagen, das eine erhöhte Lichtempfindlichkeit aufweist.

Gegenstand der Erfindung ist ein lichtempfindliches Gemisch, das ein lichtempfindliches Diazoniumsalz-Polykondensationsprodukt und eine Verbindung zur Erhöhung der Lichtempfindlichkeit enthält.

AMERICAN HOECHST CORPORATION
Somerville, N.J. 08876/USA



Das erfindungsgemäße Gemisch ist dadurch gekennzeichnet, daß die Verbindung ein unsubstituiertes oder durch eine Azo- oder Hydroxygruppe substituiertes Amin ist.

Zu den Diazoniumsalz-Polykondensationsprodukten, die erfindungsgemäß eingesetzt werden, gehören diejenigen der vorstehend genannten allgemeinen Formeln. Dabei handelt es sich z. B. um Kondensationsprodukte von Diphenylamin-4-diazoniumsulfat und Paraformaldehyd in Schwefelsäure, die als Tetrachlorozinkate isoliert werden, die Kondensationsprodukte aus 3-Methoxy-diphenylamin-4-diazoniumsulfat und 4,4'-Bis-methoxymethyl-diphenylether in Phosphorsäure, die als Naphthalin-2-sulfonat isoliert werden; Kondensationsprodukte aus Diphenylamin-4-diazoniumsulfat und Paraformaldehyd in Phosphorsäure, die als Hexafluorophosphate isoliert werden; und die Produkte der Kondensation eines oligomeren Homokondensats, das z. B. aus 4,4'-Bis-methoxymethyl-diphenylether hergestellt worden ist, mit 3-Alkoxy-4-diazo-diphenylaminsulfat in Phosphorsäure, die als Mesitylensulfonat isoliert werden. Es handelt sich hier um die oben bezeichneten Kondensationsprodukte aus Verbindungen der Formeln I und II.

Diazoniumverbindungen, denen die erfindungsgemäßen Sensibilisatoren mit dem größten Erfolg zugesetzt werden können, sind jene hochlichtempfindlichen Verbindungen, die im Bereich von 350 bis 390 nm ein Absorptionsvermögen von nicht mehr als 45 % besitzen, gemessen mit einem

AMERICAN HOECHST CORPORATION
Somerville, N.J. 08876/USA



Perkin-Elmer Spektrometer, Modell 559, unter Standardprüfbedingungen.

Die erfindungsgemäß eingesetzten, die Lichtempfindlichkeit erhöhenden Mittel sind primäre, sekundäre oder tertiäre lineare oder cyclische Amine. Sekundäre und tertiäre Amine sowie aromatische Amine, die durch Azogruppen substituiert sind, werden bevorzugt. Beispiele hierfür sind: Diphenylamin, Triphenylamin, 4-Phenylazo-diphenylamin, o-Tolylazotoluidin, t-Butyldiethanolamin und 1-Methyl-2-(2-hydroxyphenyl)-benzimidazol.

Durch die erfindungsgemäßen Zusätze wird eine erhöhte Lichtempfindlichkeit der Diazoniumverbindungen ohne nennenswerte Beeinträchtigung der Stabilität oder der Bildqualität erreicht.

Allgemein ergeben die bevorzugten Amine unter den beschriebenen Prüfungsbedingungen eine Erhöhung der Lichtempfindlichkeit um mindestens 40 %.

Das Verhältnis von Diazoniumverbindung zu dem die Lichtempfindlichkeit erhöhenden Mittel bzw. dem Sensibilisator, das zur Gewährleistung einer wirkungsvollen Lichtempfindlichkeitssteigerung gewählt werden muß, hängt sowohl von der Art der Diazoniumverbindung als auch von dem gewählten Zusatz ab. Im allgemeinen werden mit 0,005 bis 1,5 Gewichtsteilen Sensibilisator je Gewichtsteil Diazoniumverbindung gute Ergebnisse erzielt. Bevorzugt werden 0,01 bis 0,2 Gewichtsteile Sensibilisator auf 1 Gewichtsteil Diazoniumverbindung zugesetzt.

AMERICAN HOECHST CORPORATION
Somerville, N.J. 08876/USA



Die erfindungsgemäßen sensibilisierten lichtempfindlichen Gemische können in gewohnter Weise zu Reproduktionsschichten verarbeitet werden. Sie werden in einem geeigneten Lösemittel, z. B. in Wasser oder einem organischen Lösemittel, gelöst, auf Träger aufgebracht und getrocknet, so daß Farbprüffolien, Kopiervorlagen, Montagehilfen usw. erhalten werden. Geeignete Trägermaterialien sind u. a. transparente Kunststoffolien oder Papier.

Für die Herstellung von Farbprüffolien wird dem Gemisch ein geeigneter Farbstoff oder ein geeignetes Pigment, vorteilhaft in einer der Grundfarben Gelb, Blaugrün, Purpur und Schwarz, zugesetzt.

Die Beschichtungsgemische können noch weitere bekannte Zusätze enthalten, z. B. polymere Bindemittel, Weichmacher, Stabilisatoren, Netzmittel und Indikatoren. Geeignete Zusätze und polymere Bindemittel sind in der US-PS 3 867 147 beschrieben.

Alle Zusätze sollten so ausgewählt werden, daß sie sowohl mit der Diazoniumverbindung, dem Sensibilisator, dem Farbstoff und dem gegebenenfalls verwendeten polymeren Bindemittel als auch mit dem eingesetzten Lösemittel gut verträglich sind. Geeignete Lösemittel sind z. B. Wasser, niedere aliphatische Alkohole und Ether sowie aromatische und aliphatische Kohlenwasserstoffe. Geeignete polymere Bindemittel umfassen in Wasser oder wäßrig-alkalischen Lösungen lösliche Substanzen, wie Polyvinylalkohol, Polyacrylamide, Copolymere aus vinylaromatischen Verbin-

AMERICAN HOECHST CORPORATION
Somerville, N.J. 08876/USA



dungen und sauren Comonomeren wie Maleinsäureanhydrid. Es können aber auch wasserunlösliche Bindemittel wie Phenol- und Alkydharze und Acrylpolymere verwendet werden. Polymere Bindemittel werden gegebenenfalls in Mengen zwischen 1 und 50 Gewichtsteilen je Gewichtsteil Diazoniumverbindung zugesetzt.

Die erfindungsgemäßen sensibilisierten lichtempfindlichen Gemische werden am vorteilhaftesten hergestellt, indem man die Diazoniumverbindung und den Sensibilisator in einem Lösemittel löst, in dem beide Stoffe löslich sind. Diese Lösung kann noch weitere gelöste oder dispergierte Zusätze enthalten. Das Auftragen der Lösung auf einen geeigneten Träger erfolgt in bekannter Weise, z. B. durch Tamponieren, Schleudern oder einfaches Überwischen; anschließend wird das Lösemittel durch Trocknen der Beschichtung entfernt.

Vergleichsbeispiel A

Ein als Schichtträger dienendes 45 x 45 cm großes Stück einer transparenten biaxial verstreckten und thermofixierten Polyethylenterephthalatfolie wurde durch Schleudern mit der folgenden Lösung beschichtet:

| | Bestandteil | Gew.-% |
|---|---|---|
| 1. | 2-Methoxy-ethanol | 26,37 |
| 2. | Methylethylketon | 34,43 |
| 3. | Ethanol (wasserfrei) | 25,55 |
| 4. | Dimethylphthalat | 0,48 |

AMERICAN HOECHST CORPORATION
Somerville, N.J. 08876/USA



| | Bestandteil | Gew.-% |
|---|---|---|
| 5. | p-Toluolsulfonsäure | 0,35 |
| 6. | Styrol/Maleinsäureanhydrid-Copolymer (50 : 50) | 1,91 |
| 7. | Hydroxypropylcellulose | 0,012 |
| 8. | Calcozine Yellow (C.I. 41 001) | 1,64 |
| 9. | Rhodamin 6 GDN (C.I. 45 160) | 0,66 |
| 10. | Victoriareinblau FGA (C.I.42 595) | 0,60 |
| 11. | Diazoverbindung | 8,00 |

Die verwendete Diazoverbindung war das als Hexafluorophosphat isolierte Kondensationsprodukt aus Diphenylamin-4-diazoniumsulfat und Paraformaldehyd.

Die Lösung enthielt 8 g Diazoniumverbindung pro 100 g Lösung. Die Folie wurde bei 100°C zwei Minuten getrocknet, um die Lösemittelreste zu entfernen.

Die beschichtete Folie wurde in mehrere 25 x 12,5 cm große Stücke geschnitten, und eines der Stücke wurde mittels einer Quecksilberdampflampe durch eine Testvorlage mit einem 21 Stufen (Dichteunterschied $\sqrt{2}$) umfassenden Stauffer-Keil belichtet (Schicht auf Schicht). Der Vakuumkopierrahmen war mit einem Belichtungsmesser ausgestattet, der eine genaue automatische Belichtungszeiteinstellung ermöglichte. Die Belichtung erfolgte in Einheiten (1 Einheit $\approx$ 10 $mJ/cm^2$); dabei wurde jedes Muster mit 4 Einheiten belichtet. Anschließend erfolgte die Entwicklung mit einem wäßrig-alkalischen Entwickler, der Alkalisalze der Phosphor- und Kieselsäure

AMERICAN HOECHST CORPORATION
Somerville, N.J. 08876/USA



enthielt. Nach dem Entwickeln wies die Vergleichsfolie klare Bildhintergrundstellen auf. Auf dem Stufenkeil war keine gedeckte und eine teilweise gedeckte Stufe zu erkennen.

Vergleichsbeispiel B

Vergleichsbeispiel A wurde wiederholt mit der Ausnahme, daß die in diesem Falle verwendete Diazoniumverbindung das als Mesitylensulfonat isolierte Kondensationsprodukt aus 4,4'-Bis-methoxymethyl-diphenylether und 3-Methoxy-diphenylamin-4-diazoniumsulfat war. Diese und weitere Diazoniumverbindungen dieser Art sind in der US-PS 3 849 392 beschrieben.

Die beschichtete Folie wurde wie im Vergleichsbeispiel A beschrieben behandelt. Sie wies eine gedeckte und zwei teilweise gedeckte Stufen auf.

Vergleichsbeispiel C

Vergleichsbeispiel A wurde wiederholt mit der Ausnahme, daß die in diesem Fall verwendete Diazoniumverbindung aus dem Homokondensationsprodukt aus 4,4'-Bis-methoxymethyl-diphenylether bestand, das mit 3-Methoxy-diphenylamin-4-diazoniumsulfat weiterkondensiert und anschließend als Mesitylensulfonat isoliert worden war. Diese Diazoniumverbindung und weitere Diazoniumverbindungen dieser Art sind in der EP-OS 61 150 beschrieben.

Die wie in Vergleichsbeispiel A weiterverarbeitete beschichtete Folie wies zwei gedeckte und zwei teilweise gedeckte Stufen auf.

AMERICAN HOECHST CORPORATION
Somerville, N.J. 08876/USA



Beispiel 1

0,75 g Diphenylamin wurden in 99,25 g der Lösung nach Vergleichsbeispiel A durch 15-30-minütiges Rühren bei Raumtemperatur (20°C) gelöst. Eine Polyesterfolie wurde mit der filtrierten Lösung durch Schleudern beschichtet. Die beschichtete Folie wurde wie im Vergleichsbeispiel A beschrieben belichtet und entwickelt. Nach der Verarbeitung wies sie eine gedeckte und eine teilweise gedeckte Stufe auf.

Beispiel 2

0,5 g Diphenylamin wurden in 99,5 g der Beschichtungslösung aus Vergleichsbeispiel B gelöst. Mit der filtrierten Lösung wurde eine Polyesterfolie durch Schleudern beschichtet. Die beschichtete Folie wurde wie in Vergleichsbeispiel A beschrieben weiterverarbeitet. Es wurden zwei gedeckte und drei teilweise gedeckte Stufen erhalten.

Beispiel 3

0,25 g Diphenylamin wurden in 99,75 g der Lösung nach Vergleichsbeispiel C gelöst. Eine Polyesterfolie wurde mit der filtrierten Lösung durch Schleudern beschichtet. Nach der Weiterverarbeitung nach dem in Vergleichsbeispiel A beschriebenen Verfahren wurden zwei gedeckte und fünf teilweise gedeckte Stufen erhalten.

Beispiel 4

0,5 g 4-Phenylazo-1-naphthylamin wurden zu 99,5 g der Beschichtungslösung nach Vergleichsbeispiel A gegeben.

AMERICAN HOECHST CORPORATION
Somerville, N.J. 08876/USA



Durch 30-minütiges Rühren bei Raumtemperatur wurde eine Lösung hergestellt. Mit dieser Lösung wurde eine Polyesterfolie durch Schleudern beschichtet und wie in Vergleichsbeispiel A angegeben weiterverarbeitet. Es wurden eine gedeckte und zwei teilweise gedeckte Stufen erhalten.

Beispiel 5

0,75 g 4-Phenylazo-1-naphthylamin wurden in 99,25 g der Beschichtungslösung nach Vergleichsbeispiel B gelöst. Eine als Träger dienende Polyesterfolie wurde mit dieser Lösung durch Schleudern beschichtet und gemäß Vergleichsbeispiel A weiterverarbeitet. Es wurden zwei gedeckte und vier teilweise gedeckte Stufen erhalten.

Beispiel 6

0,75 g 4-o-Tolylazo-o-toluidin wurden zu 99,25 g der Beschichtungslösung nach Vergleichsbeispiel B gegeben. Durch Rühren bei Raumtemperatur wurde eine Lösung hergestellt und filtriert. Mit dieser Lösung wurde eine Polyesterfolie durch Schleudern beschichtet. Die beschichtete Folie wurde auf die in Vergleichsbeispiel A beschriebene Weise weiterverarbeitet. Es wurden zwei gedeckte und vier teilweise gedeckte Stufen erhalten.

Beispiel 7

0,25 g tert.-Butyl-diethanolamin wurden in 99,75 g der Beschichtungslösung nach Vergleichsbeispiel B gelöst. Mit der filtrierten Lösung wurde eine Polyesterfolie beschichtet. Die beschichtete Folie wurde wie im Ver-

AMERICAN HOECHST CORPORATION
Somerville, N.J. 08876/USA



gleichsbeispiel A beschrieben weiterverarbeitet. Es wurden zwei gedeckte und vier teilweise gedeckte Stufen erhalten.

Beispiel 8

0,25 g tert.-Butyl-diethanolamin wurden in 99,75 g der Lösung nach Vergleichsbeispiel C gelöst. Mit der filtrierten Lösung wurde eine Polyesterfolie beschichtet. Die beschichtete Folie wurde nach den Angaben von Vergleichsbeispiel A weiterverarbeitet. Es wurden zwei gedeckte und sechs teilweise gedeckte Stufen erhalten.

Beispiel 9

| | |
|---|---|
| Beschichtungslösung nach Vergleichsbeispiel B: | 99,6 g |
| 4-Phenylazo-diphenylamin: | 0,4 g |

Das 4-Phenylazo-diphenylamin wurde in der Beschichtungslösung durch 20-minütiges Rühren bei Raumtemperatur gelöst. Mit der filtrierten Lösung wurde eine Polyesterfolie durch Schleudern beschichtet. Nach der Weiterverarbeitung der Folie gemäß Vergleichsbeispiel A wurden eine gedeckte und vier teilweise gedeckte Stufen erhalten.

Beispiel 10

| | |
|---|---|
| Beschichtungslösung nach Vergleichsbeispiel C: | 99,8 g |
| 4-Phenylazo-diphenylamin: | 0,2 g |

Das 4-Phenylazo-diphenylamin wurde zu der Beschichtungslösung gegeben und durch 20-minütiges Rühren bei

AMERICAN HOECHST CORPORATION
Somerville, N.J. 08876/USA



Raumtemperatur gelöst. Mit der filtrierten Lösung wurde eine Polyesterfolie durch Schleudern beschichtet. Nach der Verarbeitung gemäß Vergleichsbeispiel A wurden zwei gedeckte und fünf teilweise gedeckte Stufen erhalten.

Aus Tabelle 1 ist die erhöhte Lichtempfindlichkeit der mit den erfindungsgemäßen beschichteten Folien gegenüber den Vergleichsbeispielen ersichtlich.

TABELLE 1

| Sensibilisator | Keilstufen | |
|---|---|---|
| | gedeckt | teilweise gedeckt |
| Vergleich A | 0 | 1 |
| Diphenylamin | 1 | 1 |
| Triphenylamin | 0 | 2 |
| 4-Phenylazo-1-naphthylamin | 1 | 2 |
| 4-(o-Tolylazo)-o-toluidin | 1 | 2 |
| tert.-Butyl-diethanolamin | 1 | 1 |
| Vergleich B | 1 | 2 |
| Diphenylamin | 2 | 3 |
| 4-Phenylazo-1-naphthylamin | 2 | 4 |
| 4-(o-Tolylazo)-o-toluidin | 2 | 4 |
| tert.-Butyl-diethanolamin | 2 | 4 |
| 4-Phenylazo-diphenylamin | 1 | 4 |

AMERICAN HOECHST CORPORATION
Somerville, N.J. 08876/USA



TABELLE 1 (Fortsetzung)

| Sensibilisator | Keilstufen | |
|---|---|---|
| | gedeckt | teilweise gedeckt |
| Vergleich C | 2 | 2 |
| Diphenylamin | 2 | 5 |
| 4-(o-Tolylazo)-o-toluidin | 2 | 6 |
| tert.-Butyl-diethanolamin | 2 | 6 |
| 4-Phenylazo-diphenylamin | 2 | 5 |

Tabelle 1 zeigt, daß die Sensibilisatoren der Beispiele 1 bis 10 im Vergleich mit den Vergleichsbeispielen zu einer Erhöhung der Lichtempfindlichkeit von mindestens 40 %, in manchen Fällen sogar von bis zu 300 %, führen.

Verglichen mit den Vergleichsbeispielen A, B und C besaßen die verarbeiteten Folien der Beispiele 1 bis 10 eine jeweils um 10 bis 20 % verbesserte Auflösung und Transmissionsdichte.

Die noch nicht belichteten Folien der Beispiele 1-10 wurden bei 100°C zusammen mit den ebenfalls nicht belichteten Folien gemäß den Vergleichsbeispielen A, B und C bis zu einer halben Stunde getrocknet. Danach wurden alle Folien auf die in Vergleichsbeispiel A beschriebene Art belichtet und entwickelt. Beim Ver-

AMERICAN HOECHST CORPORATION
Somerville, N.J. 08876/USA



gleich mit den Folien nach den Vergleichsbeispielen A, B und C wurde bei den Folien der Beispiele 1-10 keinerlei Beeinträchtigung der Lagerfähigkeit und Entwickelbarkeit festgestellt.

Selbstbeschichtete und vorsensibilisierte Druckplatten, bei denen die Diazoniumverbindung nicht nur ionisch an eine hydrophile Oberfläche aus Aluminium bzw. Aluminiumoxid gebunden ist, sondern außerdem mechanisch auf dieser Oberfläche verankert ist, unterscheiden sich von Kontaktfilmen und Farbprüffolien. Im Fall von Kontaktfilmen oder Farbprüffolien wird die Diazoniumverbindung durch Adhäsivkräfte auf der Oberfläche einer als Träger dienenden Polyesterfolie festgehalten. Die Ionenbindungen gegenüber Metallen tragen zu einer angestrebten höheren Druckauflage bei, während die Diazoniumverbindung im Fall von Kontaktfilmen oder Farbprüffolien zu einer feinen Differenzierung zwischen Bildstellen und Nichtbildstellen nach der Entwicklung befähigt ist.

AMERICAN HOECHST CORPORATION
Somerville, N.J. 08876/USA



## Patentansprüche

1. Lichtempfindliches Gemisch, das ein lichtempfindliches Diazoniumsalz-Polykondensationsprodukt und eine Verbindung zur Erhöhung der Lichtempfindlichkeit enthält, dadurch gekennzeichnet, daß die Verbindung ein unsubstituiertes oder durch eine Azo- oder Hydroxygruppe substituiertes Amin ist.

2. Lichtempfindliches Gemisch nach Anspruch 1, dadurch gekennzeichnet, daß das Diazoniumsalz-Polykondensationsprodukt ein Kondensationsprodukt aus wiederkehrenden Einheiten $A-N_2X$ und B ist, die durch zweibindige, von einer kondensationsfähigen Carbonylverbindung abgeleitete Zwischenglieder verbunden sind, wobei die Einheiten $A-N_2X$ sich aus Verbindungen der allgemeinen Formel

$$(R^1-R^3-)_pR^2-N_2X$$

ableiten und wobei

X das Anion der Diazoniumverbindung,
p eine ganze Zahl von 1 bis 3,
$R^1$ einen carbocyclischen oder heterocyclischen aromatischen Rest mit mindestens einer kondensationsfähigen Position,
$R^2$ eine Arylengruppe der Benzol- oder Naphthalinreihe,
$R^3$ eine Einfachbindung oder eine der Gruppen:

AMERICAN HOECHST CORPORATION
Somerville, N.J. 08876/USA



$-(CH_2)_q-NR^4-$,

$-O-(CH_2)_r-NR^4-$,

$-S-(CH_2)_r-NR^4-$,

$-S-CH_2-CO-NR^4-$,

$-O-R^5-O-$,

- O -,

- S - oder

$-CO-NR^4-$

bedeuten, worin

q eine Zahl von 0 bis 5,

r eine Zahl von 2 bis 5,

$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^5$ eine Arylengruppe mit 6 bis 12 C-Atomen ist, und

B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeutet,

AMERICAN HOECHST CORPORATION
Somerville, N.J. 08876/USA



wobei das Kondensationsprodukt im Mittel 0,01 bis 50 Einheiten B je Einheit $A-N_2X$ enthält.

3. Lichtempfindliches Gemisch nach Anspruch 1, dadurch gekennzeichnet, daß es das Amin in einer Menge von 0,005 bis 1,5 Gewichtsteilen je Gewichtsteil des Diazoniumsalz-Polykondensationsprodukts enthält.

4. Lichtempfindliches Gemisch nach Anspruch 1, dadurch gekennzeichnet, daß es ferner einen Farbstoff oder ein Farbpigment enthält.

5. Lichtempfindliches Gemisch nach Anspruch 1, dadurch gekennzeichnet, daß es ferner ein polymeres Bindemittel enthält.

6. Lichtempfindliches Gemisch nach Anspruch 1, dadurch gekennzeichnet, daß das Amin Diphenylamin, Triphenylamin, 4-Phenylazo-diphenylamin, 4-(o-Tolylazo)-o-toluidin, tert.-Butyl-diethanolamin oder 1-Methyl-2-(2-hydroxyphenyl)-benzimidazol ist.

7. Lichtempfindliches Aufzeichnungsmaterial aus einem transparenten Schichtträger und einer lichtempfindlichen Schicht, die aus einem lichtempfindlichen Gemisch gemäß Anspruch 1 besteht.

8. Lichtempfindliches Aufzeichnungsmaterial nach Anspruch 7, dadurch gekennzeichnet, daß der Schichtträger eine Kunststoffolie ist.